## Europäisches Patentamt
## European Patent Office
## Office européen des brevets

(19)

(11) Numéro de publication: **0 183 610**
**B1**

(12) **FASCICULE DE BREVET EUROPEEN**

(45) Date de publication du fascicule du brevet: **02.01.91**

(51) Int. Cl.⁵: **G 11 C 11/41, G 06 F 15/353**

(21) Numéro de dépôt: **85402253.0**

(22) Date de.dépôt: **20.11.85**

(54) Mémoire vive et circuit d'interpolation linéaire en comportant application.

(30) Priorité: **21.11.84 FR 8417738**

(43) Date de publication de la demande:
**04.06.86 Bulletin 86/23**

(45) Mention de la délivrance du brevet:
**02.01.91 Bulletin 91/01**

(84) Etats contractants désignés:
**DE GB IT NL**

(56) Documents cités:
**DE-A-1 774 258**
**US-A-3 549 904**
**US-A-4 231 097**
**US-A-4 435 787**

(73) Titulaire: **ETAT FRANCAIS représenté par le Secrétaire d'Etat aux Postes et Télécommunications et à la Télédiffusion (CENTRE NATIONAL D'ETUDES DES TELECOMMUNICATIONS) 38-40 rue du Général Leclerc**
**F-92131 Issy-les-Moulineaux (FR)**

(73) Titulaire: **TELEDIFFUSION DE FRANCE**
**10, rue d'Oradour sur Glane**
**F-75932 Paris Cédex 15 (FR)**

(72) Inventeur: **Vigarie, Jean-Pierre**
**32, rue des Tilleuls**
**F-35510 Cesson Sevigne (FR)**
Inventeur: **Carlac'h, Jean-Claude**
**7, rue du Général Nicolet**
**F-35100 Rennes (FR)**
Inventeur: **Penard, Pierre**
**5, rue Bigarré**
**F-35000 Rennes (FR)**

(74) Mandataire: **Fort, Jacques et al**
**CABINET PLASSERAUD 84, rue d'Amsterdam**
**F-75009 Paris (FR)**

Courier Press, Leamington Spa, England.

EP 0 183 610 B1

## Description

L'invention concerne les mémoires vives à lecture rapide susceptibles d'être intégrées en transistors MOS sur un substrat semiconducteur, notamment sur silicium. Elle trouve une application particulièrement importante dans le domaine des interpolateurs linéaires numériques utilisables dans de nombreux processus, tels que la synthèse sonore et la génération numérique de signaux périodiques.

On connaît déjà (US—A—3 549 904) une mémoire vive dont chaque point mémoire comporte une bascule ayant des entrées de donnée complémentaires et des transistors permettant de forcer la bascule par celui de deux fils de donnée complémentaire qui est à un niveau déterminé lorsqu'un fil de sélection est à un premier niveau déterminé, ladite bascule étant reliée à un fil de sortie par des moyens permettant de maintenir le fil de sortie au niveau haut aussi longtemps que le fil de sélection est au premier niveau, c'est-à-dire au niveau haut, et de mettre le fil de sortie au niveau correspondant à l'état de la bascule lorsque le fil de sélection est amené à l'autre niveau, c'est-à-dire au niveau bas.

Un premier résultat recherché par l'invention est la réalisation d'une mémoire dont chaque point mémoire a une constitution qui permet la lecture en un temps très bref (la durée d'un cycle d'écriture pouvant être notablement plus longue) et ne nécessite pas d'amplificateur de lecture dont le temps de traversée allongerait la durée de cycle. Un autre résultat recherché est la réalisation d'une mémoire permettant d'obtenir, simultanément et en réponse à un seul adressage, deux valeurs stockées dans des adresses successives en mémoire, par exemple de valeurs entre lesquelles on souhaite effectuer une interpolation linéaire.

L'invention vide encore à fournir un circuit d'interpolation tel que le résultat du calcul d'interpolation soit disponible en un temps qui ne dépasse pas sensiblement celui de la lecture, dans la mémoire, où est stocké un catalogue des données entre lesquelles doit être effectuée l'interpolation.

Pour atteindre ce résultat, l'invention propose notamment une mémoire selon la revendication 1.

Cette constitution permet de diminuer le temps de lecture, notamment lorsqu'on utilise une technologie N-MOS qui est, à l'heure actuelle, celle qui permet la plus grande rapidité.

La mémoire comportera en règle générale plusieurs lignes correspondant chacune à un mot binaire, regroupant plusieurs points mémoire ayant le même fil de sélection. Dans l'application de cette constitution de la mémoire à la constitution d'un interpolateur linéaire, également objet de l'invention, l'accès en lecture pourra se faire en donnant une adresse unique réelle, ayant une partie entière et une partie fractionnaire. Cette partie fractionnaire servira de base à la génération d'une valeur intermédiaire par interpolation.

Par contre, l'accès en écriture à la mémoire pourra rester analogue à l'accès à une mémoire classique et se faire uniquement par une adresse constituée par la partie entière de l'adresse en lecture.

Toujours dans le cas d'un circuit d'interpolation, la mémoire est avantageusement fractionnée en deux blocs correspondant l'un aux adresses paires, l'autre aux adresses impaires et la mémoire est associée, d'une part, à un système de décodage qui, à partir de l'adresse unique réelle (k, x), provoque la lecture des données y(k), y(k+1) inscrites aux adresses k et k+1 (k étant la partie entière de l'adresse et x étant une partie fractionnaire entre zéro et un) et, d'autre part, à un opérateur qui réalise la fonction:

$$y(k)*x+y(k+1)*(1-x) \qquad (1)$$

L'invention sera mieux comprise à la lecture de la description qui suit d'un mode particulier de réalisation donné à titre d'exemple non limitatif. La description se réfère aux dessins qui l'accompagnent, dans lesquels:

la Figure 1 est un schéma électrique d'un point mémoire suivant un mode particulier de réalisation de l'invention;

la Figure 2 représente une topologie possible du point mémoire de la Figure 1, en technologie N-MOS;

la Figure 3 est un schéma synoptique d'un circuit intégré d'interpolation réalisé suivant l'invention:

la Figure 4 montre une architecture interne possible du système de décodage du circuit de la Figure 3;

la Figure 5 est un schéma électrique d'une tranche du décodeur de ligne du système de la Figure 4;

la Figure 6 est un schéma fonctionnel du circuit interpolateur suivant l'invention;

la Figure 7 est un schéma fonctionnel montrant une application possible du circuit interpolateur suivant l'invention, constituée par un synthétiseur de signaux musicaux.

On décrira tout d'abord une réalisation particulière de point mémoire vive suivant l'invention, permettant une lecture en 20 ns et susceptible d'être incorporé à un circuit intégré à grande échelle sur silicium.

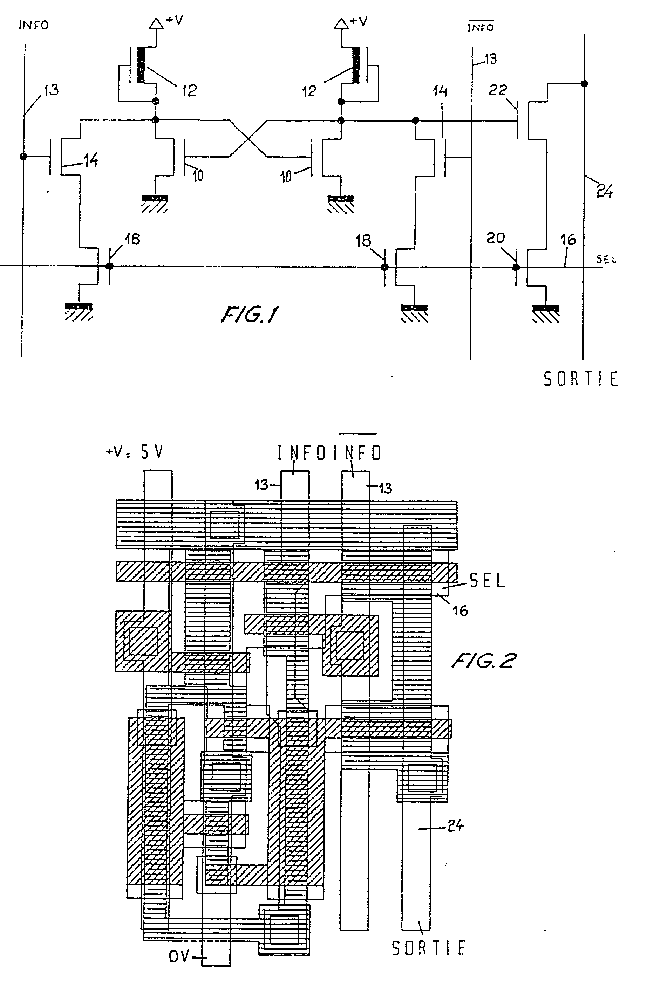

Le point mémoire montré en Figure 1 est réalisable en technologie N-MOS. Il comporte une bascule de type RS comportant deux transistors 10 montés en bistable de façon classique, dont les drains sont à la masse, les sources reliées à l'alimentation +V par des transistors complémentaires 12 et les grilles reliées aux fils de donnée d'entrée 13, marqués INFO et INFO, par l'intermédiaire de transistors 14.

Un fil de sélection 16, indiqué SEL sur les Figures, est relié à la grille de trois transistors 18 et 20 dont les drains sont à la masse. La source de chacun des transistors 18 est reliée au drain d'un transistor correspondant 14. La source du transistor 20 est reliée au drain d'un transistor de sortie 22 dont la source est connectée au fil de sortie 24 et dont la grille est reliée au drain de celui des transistors 10 qui reçoit le signal de donnée $\overline{\text{INFO}}$.

Dans ce montage, la bascule RS du point mémoire est forcée par celui des deux fils de donnée 13 qui est au niveau haut lorsque le fil de sélection 16 est lui-même au niveau haut. Le point mémoire sera donc en *mode écriture* lorsque le fil de sélection 16 est au niveau haut et qu'une donnée binaire est appliquée à l'entrée, ce qui implique que l'un des fils 13 est au niveau haut.

Après écriture, alors que la bascule a été forcée dans un état déterminé, le fil de sortie 24 reste préchargé au niveau haut, quel que soit l'état de la bascule, aussi longtemps que le fil de sélection est au niveau haut et même si les fils 13 sont revenus tous deux au niveau bas. Il s'agit là d'un mode que l'on peut qualifier de *stockage* ou de *préchargement*.

Le point mémoire passe en *mode lecture* lorsque le fil de sélection 16 est porté au niveau bas. Le fil de sortie 24 reste alors à l'état haut si la valeur stockée dans la bascule est un état bas. Il passe à l'état bas si la valeur binaire stockée est un état haut.

En technologie N-MOS, ce mode de préchargement et d'interrogation permet d'avoir une lecture rapide.

On voit que l'extraction de donnée s'effectue en un seul cycle et en un temps minimum, du fait notamment du préchargement de la mémoire (qui est en lui-même connu mais apporte, dans le cadre du circuit de l'invention, des avantages particuliers) et de l'absence d'amplificateur de lecture séparé dont le temps de traversée allongerait la durée de cycle.

La topologie du circuit de la Figure 1 peut être celle indiquée sur la Figure 2, où les masques correspondants aux différents niveaux de dopage et de métallisation sont identifiés par des hachures ou des trames différentes. Sur la Figure 2, les éléments correspondant à ceux de la Figure 1 sont indiqués par le même numéro de référence pour plus de clarté.

Pour faire apparaître le haut niveau de densité que l'on peut atteindre, il suffit de noter que la largeur de grille peut être réduite à 3,15 µm et conduit à un encombrement du point mémoire d'environ 80×60 µm.

On décrira maintenant l'application d'un point mémoire à préchargement, avantageusement du genre montré en Figures 1 et 2, à la constitution d'un circuit intégré permettant d'obtenir, à partir d'une adresse réelle X=k, x et en un seul cycle de travail, le résultat de l'opération:

$$Y=y(k)*(1-x)+y(k+1)*x$$

où

k est la partie entière de l'adresse X,
x est la partie fractionnaire de l'adresse X,
y(k) et y(k+1) sont les contenus des adresses respectives k et k+1, dans une mémoire appartenant à un circuit, k+1 étant pris modulo le nombre de mots de la mémoire.

k et x sont codés sur plusieurs éléments binaires (eb ou bit), huit par exemple.

Chaque adresse a un contenu codé sur plusieurs bits, seize par exemple.

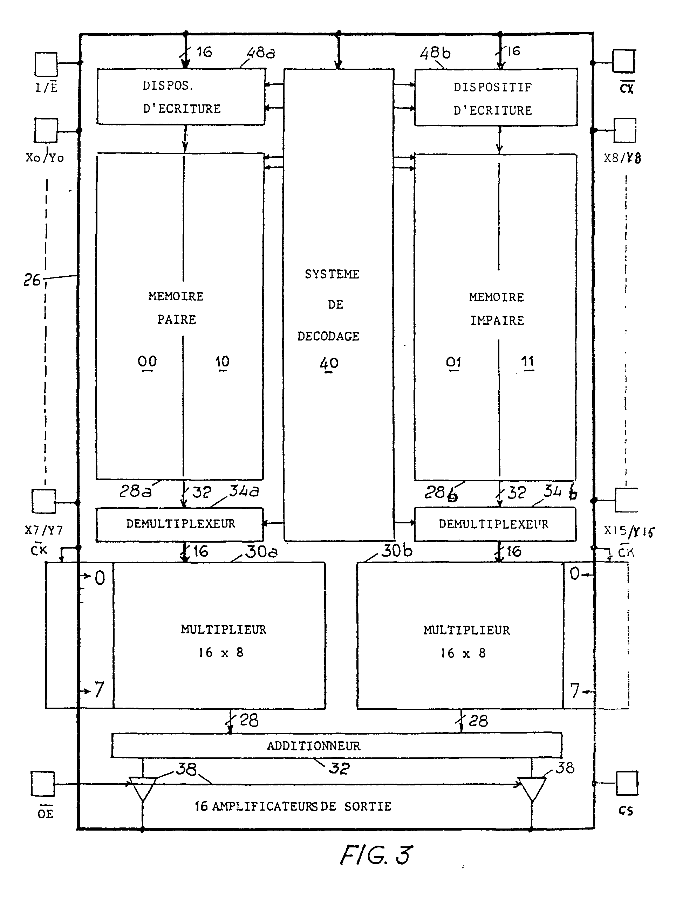

Le circuit intégré (Figure 3) peut alors être regardé comme constitué de trois parties essentielles et de leurs éléments annexes:

un bus 26 disposé à la périphérie du circuit,
une mémoire associée à un système de décodage et à des circuits d'entrée,
un opérateur d'interpolation.

Bus

Le bus 26 est bouclé en anneau afin de faciliter les interconnexions, d'améliorer le rendement de fabrication et de limiter les conséquences d'une coupure de conducteur. Au bus sont reliées les broches du boîtier du circuit. Dans le cas où les mots stockés en mémoire ont une longueur de seize bits, on pourra, par un multiplexage approprié, tel que celui qui sera mentionné plus loin, utiliser un boîtier à vingt-quatre broches classique. Seize broches sont affectées aux entrées/sorties de donnée et identifiées X0/Y0,... X15/Y15 sur la Figure 3.

Les signaux X et Y n'apparaissant pas simultanément, ils peuvent transistor par les mêmes broches du circuit intégré.

Les autres broches sont désignées, sur la Figure 3, par les abréviations suivantes:

$\overline{\text{CS}}$: sélection (chip select),

$\overline{\text{OE}}$: validation des sorties Y, permettant d'assurer le multiplexage temporel,

$\overline{\text{CX}}$: chargement par l'intermédiaire des broches X/Y,

$\overline{\text{I/E}}$: accès en lecture avec interpolation (lorsque le niveau d'entrée est à 1) ou en écriture (lorsque le niveau d'entrée est à 0).

Memoire

La mémoire est constituée d'un nombre pair de mots (deux cent cinquante-six mots de seize bits par exemple) répartis en deux blocs 28a et 28b qu'on appellera par la suite "mémoire paire" et "mémoire impaire" et qui contiennent respectivement:

les mots d'adresse paire: k=0, 2, 4,..., 254,
et les mots d'adresse impaire: k=1, 3... 255.

Chaque bloc est lui-même divisé en deux sous-blocs imbriqués, constitués chacune (dans le cas de 256 mots) de 64 mots, constituant 64 lignes. Les quatre sous-blocs sont identifiés par les nombres 00 et 10 dans la mémoire paire 28a, 01 et 11 dans la mémoire impaire 28b). Ces sous-blocs contiennent donc les adresses:

k=0, 4, 8,..., 252 pour le sous-bloc 00,
k=2, 6, 10,..., 254 pour le sous-bloc 10,
k=1, 5, 9,..., 253 pour le sous-bloc 01,
k=3, 7, 11,..., 255 pour le sous-bloc 11.

Cette organisation permet d'avoir un simple accès en écriture: l'entrée d'une donnée de 16 bits à une adresse k nécessite une opération d'écriture avec un adressage limité à k. Mais l'accès en lecture peut être aisément rendu double, l'envoi d'une adresse k entrainant la lecture des deux données d'adresse consécutives y(k) et y(k+1). Ce double accès est rendu possible par le système de décodage 40 que l'on va maintenant décrire, dans le cas particulier où la mémoire comporte deux blocks 28a et 28b de 64 lignes ayant chacune 32 points de mémoire (correspondant à deux adresses k et k+2) et un fil de sélection 16 commun. Ce fil est porté au niveau haut (SEL=1) pour sélectionner la ligne en lecture.

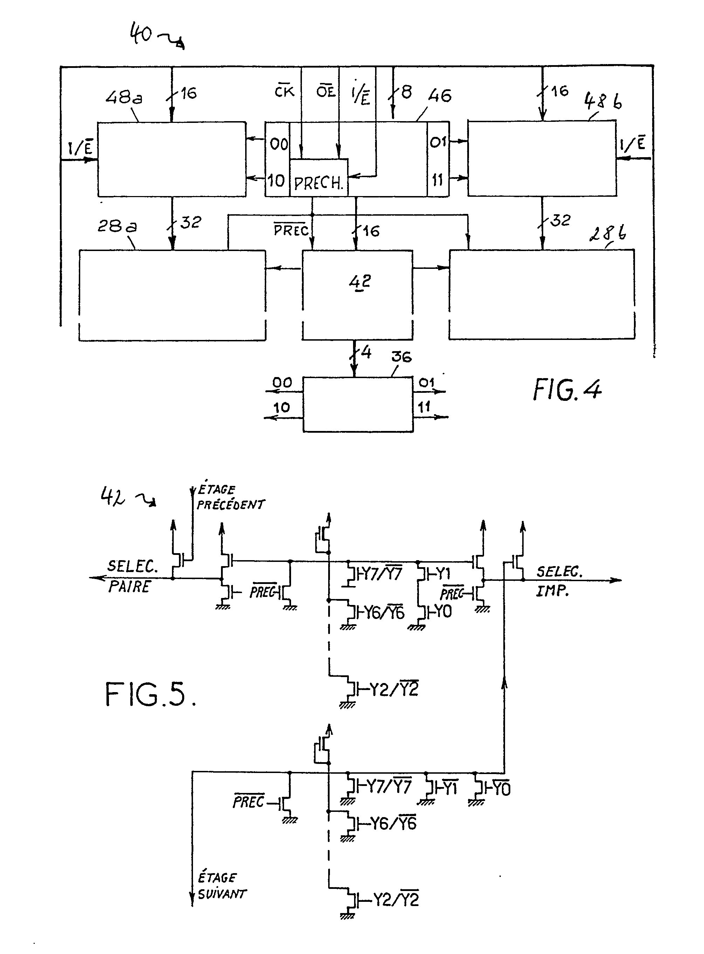

Le système de décodage 40 (Figure 4) peut être regardé comme composé de trois sous-ensembles constitués essentiellement de portes NON-OU (NOR) afin d'augmenter la rapidité. Ces sous-ensembles sont un décodeur de ligne 42, un décodeur de sortie ou décodeur de démultiplexage 36 et un décodeur d'entrée 46 qui seront successivement décrits.

La décodeur de ligne 42 contrôle l'état des fils de sélection et teste en particulier les deux bits de poids faible. Grâce à un chaînage entre étages successifs du décodeur 42, ce dernier va avoir le comportement suivant.

Si les deux bits de poids faible reçus sont différents de 11 (c'est-à-dire désignent un sous-bloc autre que le dernier de la ligne), le décodeur de ligne active deux fils de sélection de même rang dans les mémoires paire 28a et impaire 28b.

Si ces deux bits sont 11, le décodeur de ligne active la ligne d'un rang n dans la mémoire impaire 28b, la ligne de rang n+1 dans la mémoire paire 28a. Le dernier étage du décodeur 42 est rebouclé sur le premier de façon que le mot d'adresse n=255 soit suivi par le mot d'adresse n+1=0.

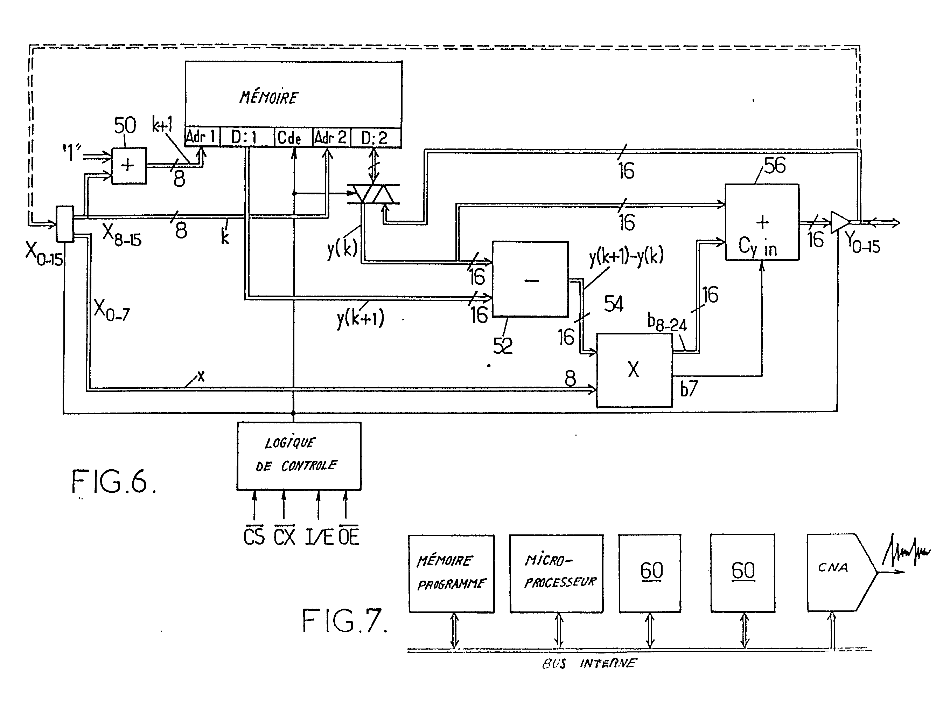

Dans la constitution montrée en Figure 5, chaque étage du décodeur de ligne 42 comporte vingt-six transistors MOS montés suivant une configuration en porte NOR permettant d'atteindre une durée de cycle ne dépassant pas 20 ns et compatible avec la durée de lecture de 20 ns qu'on peut atteindre avec le point mémoire montré en Figures 1 et 2.

Le décodeur de sortie 36 commande des démultiplexeurs de sortie 34a et 34b permettant de sélectionner, à la sortie des blocs mémoire, celui des deux mots qui doit être adressé à l'interpolateur. Ce décodeur de sortie 36 peut avoir la même constitution que le décodeur 42 mais il comporte deux étages seulement. Il provoque la sélection de celui des deux mots de seize bits présentés au démultiplexeur qui correspond, pour l'une des mémoires à l'adresse k reçue, pour l'autre mémoire à l'adresse k+1.

Ainsi, suivant la partié de l'adresse reçue, le mot y(k) sortira soit de la mémoire paire, soit de la mémoire impaire, le mot y(k+1) sortant de l'autre mémoire.

Le décodeur d'entrée 46 intervient notamment lors de l'écriture dans la mémoire.

Il doit sélectionner, parmi les quatre adresses (correspondant chacune à un mot de seize bits) activées par le décodeur de ligne, par amenée du fil de sélection à l'état haut, l'adresse où sera stockée la donnée présentée sur les fils INFO et INFO (fils de colonne). Ce décodeur est précédé d'un réseau de huit bascules de stockage d'adresse et valide les seize amplificateurs d'écriture appropriés parmi les 2×32 amplificateurs que comportent les dispositifs 48a et 48b d'écriture dans les blocs 28a et 28b.

La mémoire comporte encore des circuits d'entrée qui contrôlent et mémorisent les signaux d'entrée/sortie afin que les données et les adresses accèdent correctement à la mémoire. Ces circuits comportent des amplificateurs d'écriture, des bascules de mémorisation temporaire d'adresse, et un dispositif de préchargement, destiné à maintenir les sorties 24 à l'état haut jusqu'à la lecture.

Les amplificateurs d'écriture, au nombre de trente-deux par bloc mémoire, fabriquent, à partir d'une donnée X0,...X15 appliquée sur les broches E/S, un signal de même niveau logique pour chaque bit présenté et un signal de niveau logique complémentaire. Ils sont commandés par le signal de service I/E et un signal interne, dit "signal de forçage".

Si le signal I/E est au niveau bas, la fonction écriture est validée. Dans le cas contraire, elle est inhibée.

Si la signal de forçage est au niveau bas, le groupe de seize amplificateurs correspondant à l'adresse fournie est sélectionné et l'écriture est possible; lorsqu'au contraire le signal de forçage est au niveau haut, les sorties des amplificateurs d'écriture sont forcées au niveau bas, de façon à interdire toute modification du contenu des points mémoire correspondant au mot adressé.

Les bascules de mémorisation temporaire d'adresse sont destinées à retenir les huit bits désignant l'adresse x fournie au circuit. Ces bascules donnent également les valeurs complémentées, afin de faciliter le décodage.

Le dispositif de préchargement 47 est prévu pour fournir un signal actif, au niveau haut, quand le circuit dans son ensemble n'est ni en phase de lecture, ni en phase d'écriture. Il pré-positionne alors tous les fils de sortie de mémoire à 1. En cas de transistor à enrichissement ou à déplétion en technologie N-MOS, ce pré-positionnement diminue la durée de cycle, car les fils de sortie de la mémoire pré-positionnés à 1 passent beaucoup plus facilement à 0 qu'ils ne passeraient de 0 à 1.

Operateur d'interpolation

L'opérateur d'interpolation doit effectuer en parallèle deux multiplications de deux mots de seize bits sortant de la mémoire, l'une par le mot x constitué des huit bits de poids faible de l'adresse (partie fractionnaire de l'adresse) et l'autre par leur complément à 1.

Si le bit de poids faible de la partie entière de l'adresse vaut 0, on multiplie un mot sortant de la mémoire paire par $\simeq$ et le mot sortant de la mémoire impaire par 1−x.

Si au contraire ce dernier bit vaut 1, les multiplicateurs deviennent respectivement (1−x) et x.

Pour atteindre ce résultat, l'opérateur d'interpolation comporte deux multiplieurs identiques 30*a* et 30*b*. Chaque multiplieur effectue la multiplication de seize bits par huit bits en code complément à 2, avec un résultat tronqué aux dix-huit bits de poids fort, après correction d'arrondi.

Cette opération peut être effectuée par un multiplieur de type Booth multipliant un nombre de seize bits par un nombre de huit bits codés en complément à 2. Le nombre codé en complément à 2 sur huit bits est transformé en cinq triplets de commande du réseau logique du multiplieur. Pour accélérer le report des retenues et des sommes partielles dans le multiplieur, l'avant-dernière ligne d'additionneurs est partagée en groupes de sept bits et la retenue de ce groupe de sept bits est calculée par une logique de retenue anticipée.

Les multiplieurs sont suivis d'un additionneur 32, de type parallèle rapide. Cet additionneur effectue une troncature et une correction d'arrondi. Enfin, le réultat, codé sur seize bits dans l'exemple envisagé plus haut, est appliqué au bus par l'intermédiaire d'amplificateurs de sortie 38 commandés par l'entrée $\overline{OE}$. Des données sont ainsi disponibles sur le bus si la commande OE est au niveau bas.

L'opérateur reçoit les bits de poids faible de l'adresse, représentant la partie fractionnaire de cette adresse, depuis le bus périphérique (liaisons indiquées 0 à 7 sur la Figure 3). Ces huit bits de poids faibles sont mémorisés par deux groupes de huit bascules chacun, en amont du circuit fournissant au multiplieur soit ce mot inchangé x, soit le mot 1−x, suivant la valeur du bit de poids faible de la partie entière k de l'adresse.

Le circuit interpolateur qui vient d'être décrit peut être incorporé à de nombreux appareils, notamment à un générateur numérique de signaux périodiques, et notamment de signaux audiofréquence de haute qualité.

Un tel appareil comporte généralement un microprocesseur qui définit les signaux à générer et stocke la forme d'onde dans la mémoire du circuit interpolateur, sous forme d'échantillon. Dans une seconde étape, le microprocesseur accède à une ou plusieurs formes d'onde préalablement mémorisées par scrutation de la mémoire d'interpolateur et interpolation, de type linéaire dans le cas d'utilisation du circuit décrit plus haut.

L'appareil peut avoir la constitution de principe donnée sur le schéma fonctionnel de la Figure 7, utilisant plusieurs circuits interpolateurs 60 du genre illustré en Figure 3.

## Ecriture

Le fonctionnement en écriture est provoqué par CS. L'addresse de la ligne de mémoire où doit s'effectuer la lecture est présentée sur les entrées X0/X15 et elle est mémorisée dans le circuit par CX. Seuls les huit bits de poids fort X8—X15, représentant l'adresse k, sont pris en compte. Un seul accès à la mémoire est concerné. Les données D sont présentées sur les entrées Y0—Y15 environ 300 ns après et sont prises en compte à l'apparition de la commande I/$\overline{E}$=0.

Pour obtenir un point d'interpolation, on donne la valeur de l'abscisse correspondante, constituée par X qui est présentée sur les entrées X0—X15 et est mémorisée par la commande $\overline{CX}$. La valeur mémorisée est scindée en deux groupes de huit bits:

les bits de poids fort X8—X15, qui constituent l'adresse k en mémoire de l'échantillon amont d'interpolation:

X0—X7, partie fractionnaire x de X, destinés aux calculs d'interpolation.

Les deux adresses mémoire nécessaires sont, d'une part, k, d'autre part, k+1. Le circuit étant à double accès fournit directement deux données de seize bits y(k) et y(k+1). Le double accès en lecture est schématisé sur la Figure 6 par un additionneur 50. Les deux données de seize bits y(k) et y(k+1) entrent simultanément dans le circuit de calcul, de type combinatoire pour des raisons de vitesse.

Le cas représenté sur la Figure 6 ne correspond pas à l'algorithme (1) donné plus haut, mais à l'algorithme équivalent:

$$Y=y(k)+[y(k+1)−y(k)]*x.$$

Cet algorithme conduit à utiliser, comme circuit de calcul, un soustracteur 52 travaillant sur seize bits, suivi d'un multiplieur 54 de seize bits par huit bits et un additionneur d'arrondi 56. Le résultat du calcul peut, quel que soit le type du circuit de calcul, être émis sur les sorties Y0—Y15 par la commande $\overline{OE}$ qui intervient quelques dizaines de nanosecondes plus tard.

## Revendications

1. Mémoire vive à lecture rapide, intégrable sur substrat semiconducteur, dont chaque point mémoire comporte:

une bascule RS à deux transistors MOS (10, 10) de mémorisation dont les drains sont à la masse et les sources reliées à une source d'alimentation par l'intermédiaire de transistors de charge respectifs,

un transistor MOS de sortie (22) dont la grille est reliée à la source d'un des deux transistors de mémorisation et dont la source est reliée à un fil de sortie de lecture (24),

deux fils de données d'entrée complémentaires (INFO et $\overline{INFO}$) reliés chacun à la grille d'un transistor MOS respectif de commutation (14) dont la source est reliée à la source d'un des transistors de mémorisation, et

une ligne de sélection unique (SEL),

de sorte que le fil de sortie (24) reste au niveau haut aussi longtemps que le fil de sélection (SEL) est à un premier niveau et le fil de sortie passe au niveau correspondant à l'état de la bascule lorsque le fil de sélection est amené à l'autre niveau.

caractérisée en ce que la ligne de sélection unique (SEL) est reliée, d'une part, aux grilles de deux transistors de sélection (18) dont le drain est à la masse et la source reliée au drain d'un des transistors de commutation (14) et, d'autre part, à la grille d'un transistor (20) dont le drain est également à la masse et la source reliée au drain du transistor de sortie (22).

2. Mémoire selon la revendication 1, caractérisée en ce qu'elle est constituée en transistors N-MOS.

3. Mémoire selon la revendication 1 ou 2, caractérisée en ce qu'elle comporte plusieurs lignes correspondant chacune à un mot binaire, regroupant plusieurs points mémoire ayant le même fil de sélection (16).

4. Circuit numérique, caractérisé en ce qu'il comporte une mémoire (28a ou 28b) suivant l'une quelconque des revendications précédentes, un multiplieur (30a ou 30b) relié à la sortie de la mémoire et des moyens d'adressage recevant des adresses uniques réelles (k, x) comportant une partie entière (k) correspondant à une adresse en mémoire et une partie fractionnaire (x) entre zéro et un qui est transmise au multiplieur en tant que facteur de multiplication du contenu de l'adresse (k).

5. Circuit interpolateur linéaire numérique, caractérisé en ce qu'il comport une mémoire suivant la revendication 1, 2 ou 3, que ladite mémoire est fractionnée en deux blocs (28a, 28b) correspondant, l'un aux adresses paires, l'autre aux adresses impaires, et la mémoire est associée à un système de décodage qui, à partir de l'adresse unique réelle (k, x), provoque la lecture des données y(k), y(k+1) inscrites aux adresses k et k+1, k étant la partie entière de l'adresse et x étant une partie fractionnaire entre zéro et un, et l'opération:

$$y(k)*x+y(k+1)*(1-x).$$

6. Circuit interpolateur linéaire numérique intégrable en technologie MOS, caractérisé en ce qu'il comporte une mémoire suivant la revendication 1, 2 ou 3, que ladite mémoire est fractionnée en deux blocs correspondant, l'un aux adresses paires, l'autre aux adresses impaires, et la mémoire est associée à un système de décodage qui, à partir d'une adresse unique réelle (k, x), provoque la lecture des données y(k), y(k+1) inscrites aux adresses k et k+1, (k étant la partie entière de l'adresse et x étant une partie fractionnaire entre zéro et un, et l'opération d'interpolation:

$$y(k)+[(y(k+1)-y(k)]*x.$$

7. Circuit selon la revendication 6, caractérisé en ce que chaque bloc de mémoire (28a, 28b) est divisé en deux sous-blocs imbriqués, un même fil de sélection étant affecté à deux lignes correspondantes d'un même sous-bloc, et en ce que chaque sous-bloc comporte un démultiplexeur de sortie (34a, 34b) commandé par un système de décodage de façon à sélectionner la valeur adressée.

8. Circuit selon la revendication 7, caractérisé en ce qu'il comporte un système de décodage ayant un décodeur de ligne (42) afin d'activer les fils de sélection de même rang dans les deux blocs mémoire lorsque les deux bits de poids faible de l'adresse reçue indiquent un sous-bloc autre que le dernier de la ligne et deux fils successifs dans les deux blocs dans le cas contraire.

## Patentansprüche

1. Schnell lesbarer Schreiblesespeicher, der auf einem Halbleitersubstrat integrierbar ist und bei dem jeder Speicherplatz:

ein RS Flip-Flop-Glied mit zwei Speicher-MOS-Transistoren (10, 10), deren Drains an Masse liegen und an deren Sourcen über zwischengeschaltete Ladetransistoren eine Versorgungsquelle liegt,

einen MOS-Ausgangstransistor (22), dessen Gate mit der Source eines der beiden Speichertransistoren verbunden ist, und dessen Source an einem Leseausgang (24) liegt,

zwei komplementäre Dateneingänge (INFO und INFO), die jeweils mit dem Gate eines jeweiligen MOS-Schalttransistors (14) verbunden sind, dessen Source mit der Source eines der Speichertransistoren verbunden ist, und

eine Wählleitung (SEL) umfaßt, derart, daß der Ausgang (24) auf einem hohen Pegel solange bleibt, wie die Wählleitung (SEL) auf einem ersten Pegel liegt, und der Ausgang auf einem Pegel kommt, der dem Zustand des Flip-Flop-Gliedes entspricht, wenn die Wählleitung auf einen anderen Pegel kommt, dadurch gekennzeichnet, daß die eindeutige Wählleitung (SEL) einerseits mit den Gates von zwei Wähltransistoren (18), deren Drain an Masse liegt und deren Source mit dem Drain eines der Schalttransistoren (14) verbunden ist, und andererseits mit dem Gate eines Transistors (20) verbunden ist, dessen Drain gleichfalls an Masse liegt und dessen Source mit dem Drain des Ausgangstransistors (22) verbunden ist.

2. Speicher nach Anspruch 1, dadurch gekennzeichnet, daß er aus N-MOS-Transistoren gebildet ist.

3. Speicher nach Anspruch 1 oder 2, dadurch gekennzeichnet, daß er mehrere Leitungen aufweist, die jeweils einem binären Wort entsprechen und mehrere Speicherplätze gruppieren, die die gleiche Wählleitung (16) haben.

4. Numerische Schaltung dadurch gekennzeichnet, daß sie einen Speicher (28a oder 28b) nach einem der vorhergehenden Ansprüche, ein Multiplizierglied (30a oder 30b), das mit dem Ausgang des Speichers verbunden ist, und Adressiereinrichtungen umfaßt, an denen eindeutige echte Adressen (k, x) liegen, die einen ganzzahligen Teil (k), der einer Speicheradresse entspricht, und einen Bruchteil (x) umfassen, der zwischen null und eins liegt, und der zum Multiplizierglied als Multiplikationsfaktor für den Inhalt der Adresse (k) übertragen wird.

5. Lineare numerische Interpolationsschaltung dadurch gekennzeichnet, daß sie einen Speicher nach Anspruch 1, 2 oder 3 aufweist, der besagte Speicher in zwei Blöcke (28a, 28b) jeweils einerseits mit geradzahligen und andererseits mit ungeradzahligen Adressen aufgeteilt ist, und der Speicher einem Dekodiersystem zugeordnet ist, das mittels der echten eindeutige Adresse (k, x) das Lesen der Daten y(k), y(k+1), die an den Adressen (k) und (k+1) eingeschrieben sind, wobei (k) der ganzzahlige Teil der Adresse ist und (x) ein Bruchteil zwischen null und eins ist, und die Verknüpfungsoperation

$$y(k)*x+y(k+1)*(1-x)$$

bewirkt.

6. Numerische lineare Interpolationsschaltung, die in MOS-Technik integrierbar ist, dadurch gekennzeichnet, daß sie einen Speicher nach den Ansprüchen 1, 2 oder 3 aufweist, wobei dieser Speicher in zwei entsprechende Blöcke einerseits mit geradzahligen Adressen und andererseits mit ungeradzahligen Adresse aufgeteilt ist, und der Speicher einem Dekodiersystem zugeordnet ist, das ausgehend von einer eindeutigen echten Adresse (k, x) das Lesen der Daten y(k), y(k+1), die an den Adressen (k) und (k+1) eingeschrieben sind, wobei (k) der ganzzahlige Teil der Adresse und (x) ein Bruchteil zwischen null und eins sind, und die Interpolationsoperation

$$y(k)+[y(k+1)-y(k)]*x$$

bewirkt.

7. Schaltung nach Anspruch 6, dadurch gekennzeichnet, daß jeder Speicherblock (28a, 28b) in zwei einander überlagernde Unterblöcke unterteilt ist, wobei dieselbe Wählleitung zwei Leitungen zugeordnet ist, die demselben Unterblock entsprechen, und daß jeder Unterblock einen Ausgangsdemultiplexer (34a, 34b) aufweist, der über ein Dekodiersystem angesteuert wird, derart, daß der Adressenwert gewählt wird.

8. Schaltung nach Anspruch 7, dadurch gekennzeichnet, daß sie ein Dekodiersystem mit einer Dekodierleitung (42) aufweist, so daß die Wählleitungen mit gleichem Rang in den beiden Speicherblöcken aktiviert werden, wenn die beiden niedrigwertigen Bits der empfangenen Adresse einen anderen Unterblock als den letzten der Leitung anzeigen, und im entgegengesetzten Fall die folgenden beiden Leitungen der beiden Blöcke aktiviert werden.

## Claims

1. A fast read-write memory integrable on a semiconductor substrate, each memory point of which comprises:

a RS flip-flop having two MOS storage transistors (10), whose drains are grounded and whose sources are connected to a supply source through respective load transistors,

a MOS output transistor (22) whose grid is connected to the source of one of the two storage transistors and whose source is connected to a read-out output line (24),

two complementary input data lines (INFO and INFO) each connected to the grid of a respective MOS switching transistor (14) whose source is connected to the source of one of the storage transistors, and

a single selection line (SEL),

whereby the output line (24) remains at the high level as long as the selection line (SEL) is at a first level and the output line takes a level corresponding to the condition of the flip-flop when the selection line is brought to the other level,

characterized in that the single selection line (SEL) is connected, on the one hand, to the grids of two selection transistors (18) whose drain is grounded and whose source is connected to the drain of one of the switching transistors (14) and, on the other hand, to a grid of a transistor (20) whose drain is also grounded and whose source is connected to the drain of the output transistor (22).

2. Memory according to Claim 1, characterized in that the transistors are N-MOS transistors.

3. Memory according to Claim 1 or 2, characterized in that it comprises a plurality of lines each corresponding to a binary word, including a plurality of memory points having the same selection line (16).

4. Digital circuit, characterized in that it comprises a memory (28a or 28b) according to any one of the preceding Claims, a multiplier (30a or 30b) connected to the output of the memory and addressing means receiving single real addresses (k, x) comprising a whole part (k) corresponding to an address in the memory and a fractional part (x) between zero and one, which is applied to the multiplier as a multiplicand of the content at address (k).

5. Digital linear interpolating circuit, characterized in that it comprises a memory according to Claim 1, 2 or 3, in that said memory is split into two blocks (28a, 28b) one corresponding to even addresses and the other to odd addresses and the memory is associated with a decoding system which, starting from the single real address (k, x), causes read-out of the data y(k), y(k+1) written at addresses k and k+1, k being the whole part of the address and x being a fractional part between zero and one and the operation:

$$y(k)*x+y(k+1)*(1-x).$$

6. Digital linear interpolating circuit for integration in MOS technology, characterized in that it comprises a memory according to Claim 1, 2 or 3, in that said memory is split into two blocks, one corresponding to even addresses and the other to odd addresses and the memory is associated with a decoding system which, starting from a single real address (k, x), causes read-out of the data y(k), y(k+1) written at addresses k and k+1 (k being the whole portion of the address and x being a fractional part between zero and one) and the interpolation operation:

$$y(k)+[(y(k+1)-y(k)]*x.$$

7. Circuit according to Claim 6, characterized in that each memory block (28a, 28b) is split into two imbricated sub-blocks, a same selection wire being dedicated to two corresponding rows in a same sub-block and in that each sub-block has an output demultiplexer (34a, 34b) controlled by a decoding system for selecting the addressed value.

8. Circuit according to Claim 7, characterized in that it comprises a decoding system having a line decoder (42) for energizing those selection lines which have the same order in the two memory blocks when the two LSBs of the received address indicate a sub-block other than the last sub-block of the line and two successive lines in the two blocks in the opposite situation.

FIG.1

FIG.2

1

FIG. 3

FIG.4

FIG.5.

3

FIG.6.

FIG.7.

MÉMOIRE

50   k+1

'1'   +

X_{0-15}   X_{8-15}   8   k

X_{0-7}

X   x

Adr 1   D:1   Cde   Adr 2   D:2

8

y(k)

y(k+1)

16   16

52

—   y(k+1)−y(k)   54

16   16   b_{8-24}   16

X   b7

8

16

16

56   +   Cy in

16   Y_{0-15}

LOGIQUE DE CONTROLE

$\overline{CS}$   $\overline{CX}$   I/E   $\overline{OE}$

MÉMOIRE PROGRAMME   MICRO-PROCESSEUR   60   60   CNA

BUS INTERNE

EP 0 183 610 B1